Europäisches Patentamt

European Patent Office

Office européen des brevets

(11) Veröffentlichungsnummer: **0 036 042 A2**

## (12) EUROPÄISCHE PATENTANMELDUNG

(21) Anmeldenummer: **80107769.4**

(22) Anmeldetag: **10.12.80**

(51) Int. Cl.³: **H 03 H 9/08**
**H 03 L 1/04**

(30) Priorität: **15.03.80 DE 3010059**

(43) Veröffentlichungstag der Anmeldung:
**23.09.81 Patentblatt 81/38**

(84) Benannte Vertragsstaaten:
**AT BE DE FR GB IT NL**

(71) Anmelder: **ROBERT BOSCH GMBH**
**Postfach 50**
**D-7000 Stuttgart 1(DE)**

(72) Erfinder: **Franke, Manfred**
**Stubenrauchstrasse 53**
**D-1000 Berlin 41(DE)**

(74) Vertreter: **Schmidt, Hans-Ekhardt**
**Robert Bosch GmbH Geschäftsbereich Elektronik**
**Patent- und Lizenzabteilung Forckenbeckstrasse 9-13**
**D-1000 Berlin 33(DE)**

(54) **Einrichtung zum Begrenzen temperaturbedingter Frequenzschwankungen eines quarzgesteuerten Hochfrequenzoszillators.**

(57) Es wird eine Einrichtung zum Begrenzen temperaturbedingter Frequenzschwankungen eines quarzgesteuerten Hochfrequenzoszillators gemäß Patentanmeldung P 18 10 274.4-35 vorgeschlagen, bei der eine Heizvorrichtung für einen Quarz vorgesehen ist, die von einer Regelschaltung derart geregelt wird, daß sie die Umgebungstemperatur des Quarzes auf einer Temperatur annähernd konstant hält, die am unteren Rande eines flachen Kurvenverlaufes der Frequenz/Temperaturcharakteristik des Quarzes liegt. Die Regelung der Heizvorrichtung wird dabei in der Weise bewirkt, daß ein Kaltleiterwiderstand verwendet wird, der in thermisch leitender Verbindung zum Quarz angeordnet ist.

./...

18/80
EK/PLI Wt/Li
12. 3. 1980

ROBERT BOSCH GMBH, 7000 Stuttgart 1

Einrichtung zum Begrenzen temperaturbedingter
Frequenzschwankungen eines quarzgesteuerten
Hochfrequenzoszillators

## Stand der Technik

Die Erfindung geht aus von einer Einrichtung nach der
Gattung des Hauptanspruchs.

In der vorveröffentlichten Patentanmeldung P 18 10 274.4-35
ist eine Einrichtung zum Begrenzen temperaturbedingter
Frequenzschwankungen eines quarzgesteuerten Hochfrequenzoszillators beschrieben. Dabei wird von einer Frequenz/
Temperaturcharakteristik des Quarzes ausgegangen, die einer
Funktion dritten Grades entspricht, wobei der Wendepunkt der
Funktion gerade der Sollfrequenz entspricht. Die zugelassene
Frequenzabweichung von der Sollfrequenz führt in etwa zu
symmetrischen Temperaturwerten, bezogen auf den Wendepunkt
der Charakteristik. Der Quarz ist mit einer Heizvorrichtung
mit einer Regelschaltung versehen, wobei der Temperatureinsatzpunkt der Regelschaltung auf den Temperaturwert gelegt
wird, der dem unteren Frequenzgrenzwert des zugelassenen Frequenzbereiches entspricht. Dies bewirkt, daß nur
Temperaturen unterhalb der Grenztemperatur durch die
Heizvorrichtung ausgeglichen werden müssen, während
Temperaturen oberhalb der Grenztemperatur aufgrund
des flachen Verlaufes der Frequenz/Temperaturcharakteristik nur zu geringen Frequenzabweichungen führen.
Die Einrichtung weist weiterhin eine elektronische
Regelschaltung für die Heizvorrichtung auf, die aus
einer Vielzahl von aktiven und passiven elektronischen
Bauelementen besteht.

## Vorteile der Erfindung

Die erfindungsgemäße Einrichtung mit den kennzeichnenden Merkmalen des Hauptanspruchs hat demgegenüber den
Vorteil, daß eine Regelung und Heizung des Quarzes mit
nur einem Bauelement möglich ist und dadurch ein besonders preisgünstiger Aufbau der erfindungsgemäßen Einrichtung möglich ist.

## Zeichnung

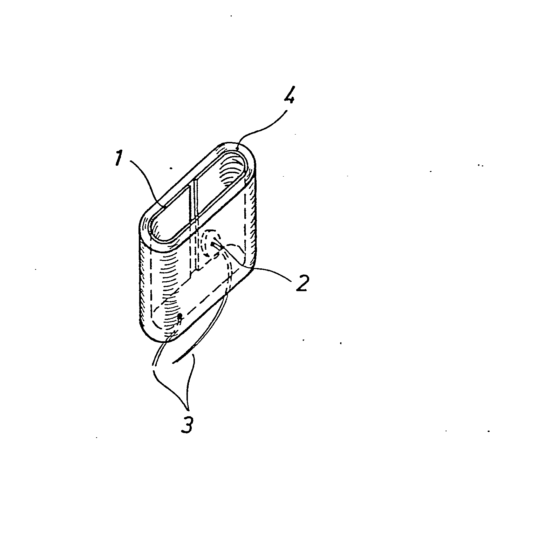

Die Erfindung ist in der Zeichnung dargestellt und in
der nachfolgenden Beschreibung näher erläutert. Die
einzige Figur zeigt eine federnde Kupferschelle mit
einem Heiz- und Regelelement.

## Beschreibung des Ausführungsbeispiels

Bei der in der Figur dargestellten Einrichtung ist mit
1 eine geschlitzte federnde Kupferschelle bezeichnet,
deren Form so gewählt ist, daß sie federnd auf den Quarz
aufgeschoben werden kann. Auf der Kupferschelle 1 ist
ein vorzugsweise scheibenförmig ausgebildeter Kaltleiterwiderstand 2 derart befestigt, daß seine eine scheibenförmige
Elektrode elektrisch und thermisch leitend mit der Kupferschelle 1 verbunden ist. Von der anderen scheibenförmigen
Elektrode führt eine Zuleitung 3 zu einer in der Figur nicht
dargestellten Stromversorgung, wobei die zweite Zuleitung mit
der Kupferschelle 1 verbunden ist. Die Anordnung aus Kupferschelle 1 und Kaltleiterwiderstand 2 ist von einem Isoliermantel 4 umgeben. Kaltleiterwiderstände haben die Eigenschaft,
daß sie bei niedrigen Temperaturen gut leiten und bei hohen
Temperaturen schlecht leiten. Dieses Verhalten entspricht jedoch dem gewünschten Heizverhalten der Einrichtung entsprechend der Hauptanmeldung in der Weise, daß die Heizleistung
mit abnehmender Temperatur zunimmt. Dies kann zum Beispiel
dadurch bewirkt werden, daß die Zuleitungen an eine konstante
Spannung angeschlossen werden, so daß bei sinkender Temperatur
und abnehmendem Widerstand des Kaltleiterwiderstandes 2 die
Heizleistung ansteigt.

Der Isoliermantel 4 besteht vorzugsweise aus einem wärmeisolierenden Schaumstoffmaterial.

18/80
EK/PLI Wt/Li
12. 3. 1980


ROBERT BOSCH GMBH, 7000 Stuttgart 1


Ansprüche

1. Einrichtung zum Begrenzen der Frequenzschwankungen eines quarzgesteuerten Hochfrequenzoszillators auf einen vorgegebenen Frequenzbereich mit der oberen Grenze $f_o$ und der unteren Grenze $f_u$ bei Schwankungen der Raumtemperatur unterhalb einer vorgegebenen oberen Temperaturgrenze $T_o$, wobei der Quarz des Hochfrequenzoszillators einen AT-Schnitt und eine derartige, durch eine Gleichung dritten Grades bestimmte Frequenz-Temperatur-Kennlinie hat, daß bei der vorgegebenen oberen Temperaturgrenze $T_o$ die obere Frequenzgrenze $f_o$ nicht überschritten wird, und wobei eine Heizvorrichtung, die nur bei Raumtemperaturen unterhalb einer Temperatur $T_u$, die um denselben Betrag unterhalb der durch den Wendepunkt der Kennlinie bestimmten Temperatur $T_s$ wie die obere Temperaturgrenze $T_o$ oberhalb der Temperatur $T_s$ in Betrieb ist, und wobei ferner die Heizvorrichtung von einer Regelschaltung derart geregelt wird, daß sie die Umgebungstemperatur des Quarzes auf der Temperatur $T_u$ annähernd konstant hält (nach Patentanmeldung P 18 10 274.4-35), dadurch gekennzeichnet, daß zur Heizung und Regelung ein Kaltleiterwiderstand (2) verwendet wird, der in thermisch leitender Verbindung zum Quarz angeordnet ist.

2. Einrichtung nach Anspruch 1, dadurch gekennzeichnet, daß der Kaltleiterwiderstand (2) auf einer geschlitzten Kupferschelle (1) befestigt ist, die außen mit einem Isoliermantel (4) umgeben und auf den Quarz aufschiebbar ist.